(19) Europäisches Patentamt
European Patent Office
Office européen des brevets

(11) **EP 3 965 029 A1**

(12) **EUROPEAN PATENT APPLICATION**

(43) Date of publication:
**09.03.2022  Bulletin 2022/10**

(51) International Patent Classification (IPC):
**G06Q 10/04** (2012.01)    **G06Q 50/28** (2012.01)

(21) Application number: **21189375.5**

(52) Cooperative Patent Classification (CPC):
**G06Q 10/047; G06Q 50/28**

(22) Date of filing: **03.08.2021**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.09.2020  US 202017012497**

(71) Applicant: **FUJITSU LIMITED
Kanagawa 211-8588 (JP)**

(72) Inventors:
• **Mandal, Avradip
  Sunnyvale, 94085 (JP)**
• **Roy, Arnab
  Sunnyvale, 94085 (JP)**
• **Upadhyay, Sarvagya
  Sunnyvale, 94085 (JP)**
• **Ushijima-Mwesigwa, Hayato
  Sunnyvale, 94085 (JP)**

(74) Representative: **Hoffmann Eitle
Patent- und Rechtsanwälte PartmbB
Arabellastraße 30
81925 München (DE)**

(54) **SOLVING OPTIMIZATION PROBLEMS ASSOCIATED WITH MARITIME FACILITY ON OPTIMIZATION SOLVER MACHINES**

(57)    According to an aspect of an embodiment, operations include receiving a layout of a maritime facility and a first input including a vehicle count associated with a fleet of transport vehicles on the maritime facility. The operations further include determining a weighted graph representation of the maritime facility based on the received layout and generating a Quadratic Unconstrained Binary Optimization (QUBO) formulation based on the weighted graph representation and the received first input. The operations further include submitting the generated QUBO formulation to a first optimization solver machine and receiving a first solution of the submitted QUBO formulation. The operations further include determining a set of paths to be traversed by the fleet of transport vehicles on the maritime facility for transporting the plurality of shipping containers to respective destination locations based on the received first solution.

FIG. 1

**Description**

FIELD

The embodiments discussed in the present disclosure are related to solving optimization problems associated with a maritime facility on optimization solver machines.

BACKGROUND

Maritime trade involves transportation of shipping containers through sea or inland waterways using ships. Loading and unloading time of the shipping containers is of utmost importance to many stakeholders, such as shipping companies, ship owners, industries which require on-time delivery of their shipment, or managers of a maritime facility (such as a seaport or an inland port). After being unloaded from a ship, shipping containers are typically stored at temporarily storage locations on the maritime facility, from where the shipping containers are typically transported to their respective destinations by transport vehicles.

The subject matter claimed in the present disclosure is not limited to embodiments that solve any disadvantages or that operate only in environments such as those described above. Rather, this background is only provided to illustrate one example technology area where some embodiments described in the present disclosure may be practiced.

SUMMARY

According to an aspect of the disclosure, operations may include receiving a layout of a maritime facility. The layout of the maritime facility may include current location information associated with a plurality of shipping containers and destination location information associated with the plurality of shipping containers. The operations may further include receiving a first input which includes a vehicle count associated with a fleet of transport vehicles on the maritime facility. The operations may further include determining a weighted graph representation of the maritime facility based on the received layout and generating a Quadratic Unconstrained Binary Optimization (QUBO) formulation based on the weighted graph representation and the received first input The QUBO formulation may model a vehicle routing problem associated with the fleet of transport vehicles. The operations may further include submitting the generated QUBO formulation to a first optimization solver machine and receiving a first solution of the submitted QUBO formulation from the first optimization solver machine. The operations may further include determining set of paths to be traversed by the fleet of transport vehicles on the maritime facility for transporting the plurality of shipping containers to destination locations included in the destination location information based on the received first solution.

The objects and advantages of the embodiments will be realized and achieved at least by the elements, features, and combinations particularly pointed out in the claims.

Both the foregoing general description and the following detailed description are given as examples and are explanatory and are not restrictive of the invention, as claimed.

BRIEF DESCRIPTION OF THE DRAWINGS

Example embodiments will be described and explained with additional specificity and detail through the use of the accompanying drawings in which:

FIG. 1 is a diagram representing an exemplary network environment for solving optimization problems associated with a maritime facility,
FIG. 2 is a block diagram of a system for solving optimization problems associated with a maritime facility,
FIG. 3 is a diagram that illustrates exemplary operations for solving optimization problems associated with a maritime facility,
FIG. 4 is a diagram that illustrates exemplary operations for solving optimization problems when a vehicle count on a maritime facility is greater than one, and
FIG. 5 is a flowchart of an example method for solving optimization problems on different optimization solver machines,

all according to at least one embodiment described in the present disclosure.

DESCRIPTION OF EMBODIMENTS

Embodiments of the present disclosure are explained with reference to the accompanying drawings.

Some embodiments described in the present disclosure relate to methods and systems for solving optimization problems associated with efficient resource utilization of a maritime facility. Maritime trade involves transportation of shipping containers through sea or inland waterways using ships. Loading and unloading time of the shipping containers is of utmost importance to many stakeholders, such as shipping companies, ship owners, industries which require on-time delivery of their shipment, or managers of a maritime facility (such as a seaport or an inland port).

After a ship loaded with containers arrives at the maritime facility, heavy duty vehicles (such as cranes) may unload shipping containers from the ship and may place the shipping containers at temporary storage locations of the maritime facility. Those shipping containers may be stored on such locations for a specific period of time. Thereafter, they may be moved to their respective destination locations on the maritime facility with the help of a fleet of transport vehicles (such as container trucks).

Maritime facilities, such as seaports face many problems in logistics, such as a problem of reducing time vessels (i.e. ships) spend on a port by maximizing productivity and utilization of physical port resources, a problem of saving on transshipment rates by rapidly moving containers from a source to a destination, and a problem of optimizing overall dispatching strategies for efficient operation of port logistics. All of these problems are often computation expensive and NonDeterministic Polynomial-Time (NP) hard.

The present disclosure may address all such problems by providing a solution which helps in efficient utilization of port resources, such as transport vehicles. Specifically, the present disclosure provides a solution to an optimization problem of routing transport vehicles for moving shipping containers from temporary storage locations to respective destination locations in an optimal amount of time. With efficient utilization of the port resources (such as transport vehicles), offloading costs, transshipment costs, and container congestion may reduce on the maritime facility, leading to a maximization of operational revenues.

For routing a transport vehicle, an optimal path may have to be determined. The optimal path may specify an order in which the transport vehicle may pick up shipping containers from the temporary storage locations and drop at the respective destination locations. In order to find such path(s) of the fleet of transport vehicles, optimization solver machines may be utilized. To solve the optimization problem on the optimization solver machines, a layout of a maritime facility and a vehicle count associated with the fleet of transport vehicles may be received. A weighted graph representation of the maritime facility may be determined based on the received layout and a Quadratic Unconstrained Binary Optimization (QUBO) formulation of the optimization problem may be generated based on the determined weighted graph and the vehicle count

The generated QUBO formulation may be solved to determine a set of paths to be traversed by the fleet of transport vehicles on the maritime facility for transporting the plurality of shipping containers to respective destination locations in an optimal amount of time. Each path may have a minimum cost (e.g., in terms of a path length) associated with it Also, the path to be traversed by the fleet of transport vehicles may be determined in a tractable amount of time as compared to an intractable time taken by the conventional approaches for solving an NP-hard problem.

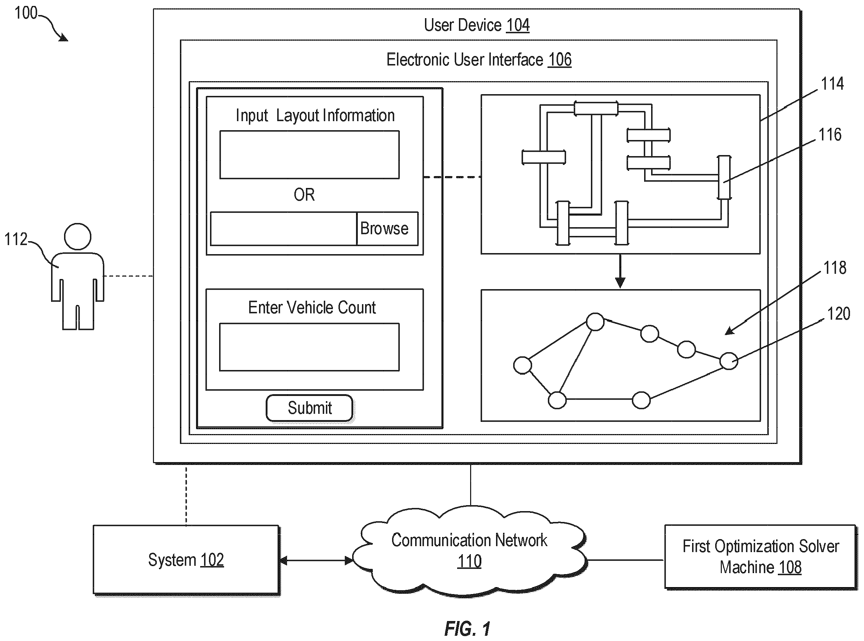

FIG. 1 is a diagram representing an exemplary network environment for solving optimization problems associated with a maritime facility, arranged in accordance with at least one embodiment described in the present disclosure. With reference to FIG. 1, there is shown a network environment 100. The network environment 100 includes a system 102, a user device 104, and a first optimization solver machine 108. The system 102, the user device 104, and the first optimization solver machine 108 may be communicatively coupled to each other, via a communication network 110. There is further shown a user 112 who may be associated with the user device 104.

The system 102 may be a part of an on-premise computing environment associated with the user 112. The system 102 may include suitable logic, circuitry, and interfaces that may be configured to display a set of user-editable templates onto an electronic User Interface (UI) 106 of the user device 104. Each of the set of user-editable templates may be used to receive an input from the user 112. Through the input, the user 112 may be able to select and configure an optimization problem, such as a vehicle routing problem. Herein, the vehicle routing problem may be an optimization problem of finding a set of paths (optimal) that a fleet of transport vehicles on the maritime facility, may traverse to transport the plurality of shipping containers 116 to respective destination locations on the maritime facility in a shortest amount of time (or a shortest travel distance or a path length).

The system 102 may include the user device 104 as part of the on-premise computing environment. The user device 104 may include a suitable network interface to communicate with the first optimization solver machine 108. Examples of the user device 104 may include, but are not limited to, a mobile device, a desktop computer, a laptop, a computer workstation, or a server, such as a cloud server. The electronic UI 106 may be displayed on the user device 104 to receive, through a user input, a layout 114 of a maritime facility. In an embodiment, the system 102 may receive a layout 114 of the maritime facility, such as a seaport or an inland port. The layout 114 may include current location information associated with a plurality of shipping containers 116 and destination location information associated with the plurality of shipping containers 116. In some embodiments, the layout 114 may show a network of roads connecting current locations (included in the current location information) of the plurality of shipping containers 116 with destination locations (included in the destination location information). For each shipping container, the current location information may include a location identifier, such as geolocation coordinates of a temporary storage location where the respective shipping container may be stored. Similarly, for each shipping container, the destination location information may include a location identifier, such as geolocation coordinates of a destination location associated with the respective shipping container.

Through the electronic UI 106, the system 102 may receive a first input The first input may include a vehicle count associated with the fleet of transport vehicles on the maritime facility. Each of the plurality of shipping containers 116 may be required to be transported from a current location (included in the current location information) to a destination location (included in the destination location information) via a transport vehicle in the fleet of transport vehicles.

The system 102 may determine a weighted graph representation 118 of the maritime facility based on the received layout 114. The weighted graph representation 118 may include a plurality of nodes 120 and a plurality of edges. Each of the plurality of nodes 120 may represent a shipping container of the plurality of shipping containers 116. Each edge of the weighted graph representation 118 may include a first node representative of a first shipping container and a second node representative of a second shipping container. On each edge connecting the first node to the second node, a destination location may exist for a shipping container placed at one of the locations of the first node and the second node.

Each edge of the weighted graph representation 118 may have an associated weight value. The weight value may be cumulative of a first distance between the current location of the first shipping container and the destination location of the first shipping container and a second distance between the destination location of the first shipping container and a current location of the second shipping container.

After the weighted graph representation 118 is determined, the system 102 may generate a quadratic unconstrained binary optimization (QUBO) formulation based on the weighted graph representation 118 and the received first input The QUBO formulation may model the vehicle routing problem associated with the fleet of transport vehicles.

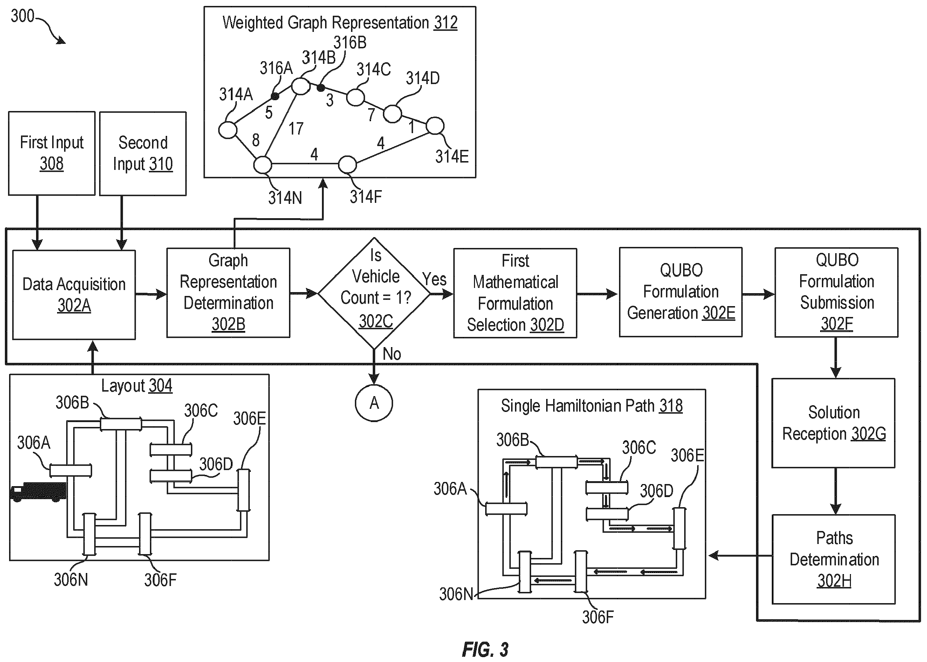

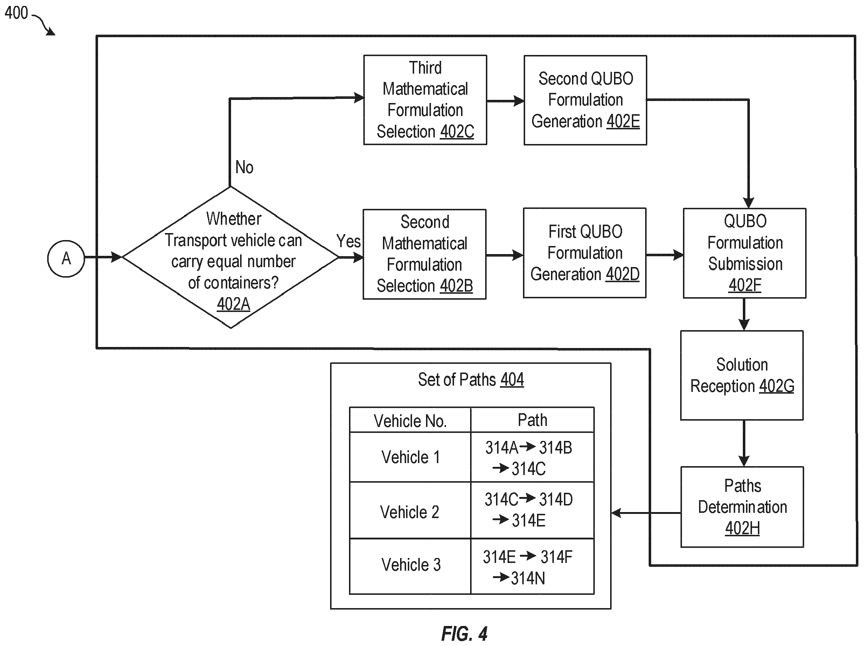

In an embodiment, the QUBO formulation may be generated by converting a mathematical formulation of the optimization problem of finding optimal path(s) for the fleet of transport vehicles on the maritime facility. The mathematical formulation may be selected from a set of mathematical formulations based on whether certain condition(s) associated with the vehicle count and the optimization problem is (are) met The mathematical formulation may include an objective function and a set of constrains associated with the objective function. The objective function may need to be optimized to determine a set of paths to be traversed by the fleet of transport vehicles on the maritime facility for transporting the plurality of shipping containers 116 to the destination locations (included in the destination location information). The determination of the mathematical formulation is described in detail, for example, in FIGs. 3, and 4.

The generated QUBO formulation may be a compatible input format for the first optimization solver machine 108. The generated QUBO formulation may include a cost matrix (Q) of constants associated with a vector of binary decision variables (x). Each variable in the vector of binary decision variables may encode a position of a shipping container of the plurality of shipping containers 116.

The generated QUBO formulation may be submitted via one or more application programming interface (API) calls to the first optimization solver machine 108. These API calls may be used to deliver a request from the system 102 to the first optimization solver machine 108 and then relay a response to the request back from the first optimization solver machine 108 to the system 102. The first optimization solver machine 108 may receive the QUBO formulation and may compute a first solution of the QUBO formulation by using optimization solving methods, such as quantum annealing or simulated annealing.

In one or more embodiments of the disclosure, the first optimization solver machine 108 may be implemented as a generalized quantum computing device that may be hosted on a cloud optimization system. The cloud optimization system may be implemented as one of a private cloud, a public cloud, or a hybrid cloud. In such an implementation, the generalized quantum computing device may use specialized optimization solving software applications (e.g., a QUBO solver) at an application layer to implement searching algorithms or meta-heuristic algorithms, such as simulated annealing or quantum annealing, to search for the solution of the QUBO formulation from a discrete solution space.

The generalized quantum computing device may be different from a digital bit-based computing device, such as digital devices that are based on transistor-based digital circuits. The generalized quantum computing device may include one or more quantum gates that use quantum bits (hereinafter referred to as "qubits") to perform computations for different information processing applications, such as quantum annealing computations for solving the QUBO formulation. In general, a qubit can represent "0", "1", or a superposition of both "0" and "1". In most cases, the generalized quantum computing device may need a carefully controlled cryogenic environment to function properly. The generalized quantum computing device uses certain properties found in quantum mechanical systems, such as quantum fluctuations, quantum superposition of its Eigenstates, quantum tunneling, and quantum entanglement. These properties may help the generalized quantum computing device to perform computations for solving certain mathematical problems (e.g. QUBO functions) which are computationally intractable by conventional computing devices. Examples of the generalized quantum computing device may include, but are not limited to, a silicon-based nuclear spin quantum computer, a trapped ion quantum computer, a cavity quantum-electrodynamics (QED) computer, a quantum computer based on nuclear spins, a quantum computer based on electron spins in quantum dots, a superconducting quantum computer that uses superconducting loops and Josephson junctions, and nuclear magnetic resonance quantum computer.

In some other embodiments, the first optimization solver machine 108 may be a quantum annealing computer that may be specifically designed and hardware/software optimized to implement searching algorithms or meta-heuristic algorithms, such as simulated annealing or quantum annealing. Similar to the generalized quantum computing device, the quantum annealing computer may also use qubits and may require a carefully controlled cryogenic environment to function properly.

In some other embodiments, the first optimization solver machine 108 may be a digital quantum-computing processor for solving the QUBO formulation. More specifically, the first optimization solver machine 108 may be a digital annealer that may be based on a semiconductor-based architecture. The digital annealer may be designed to model the functionality of the quantum annealing computer on a digital circuitry. The digital annealer may operate at room temperature and may not require cryogenic environment to function. Also, the digital annealer may have a specific form factor that may allow it to fit on a circuit board that may be small enough to slide into the rack of a computing device or a computing infrastructure, such as a data center.

In some other embodiments, the first optimization solver machine 108 may include a processor to execute software instructions associated with one or more searching algorithms and/or meta-heuristic algorithms, such as simulated annealing or quantum annealing. Examples of the implementation of the processor may include, but are not limited to, a Reduced Instruction Set Computing (RISC) processor, an Application-Specific Integrated Circuit (ASIC) processor, a Complex Instruction Set Computing (CISC) processor, a Graphical Processing Unit (GPU), a Co-processor, and/or a combination thereof.

The first optimization solver machine 108 may transmit the computed first solution to the system 102. The system 102 may receive the solution from the first optimization solver machine 108. Based on the received first solution, the system 102 may determine a set of paths to be traversed by the fleet of transport vehicles on the maritime facility for transporting the plurality of shipping containers 116 to respective destination locations. For the first transport vehicle of the fleet of transport vehicles, the determined set of paths may include a first path, which may determine an order in which the first transport vehicle may be required to transport one or more shipping containers of the plurality of shipping containers 116 to respective destination location(s) such that a length of the first path is shortest

In some embodiments, the system 102 may further publish the determined set of paths on the user device 104. For example, the set of paths may be displayed on the electronic UI 106. In these or other embodiments, information associated with the set of paths may be committed to a route planning database. The system 102 may communicate instructions to the fleet of transport vehicles for transporting the plurality of shipping containers 116 to respective destination locations. Such instructions may be communicated based on the information associated with the set of paths in the route planning database. In some embodiments, at least one transport vehicle in the fleet may be an autonomous vehicle (for example, as per levels of driving automation defined by Society of Automotive Engineers (SAE)). In such implementations, the communicated instructions may include datapoints based on which the autonomous vehicle(s) of the fleet may autonomously operate to transport one or more shipping container of the plurality of shipping containers 116 to respective destination location(s).

It should be noted that the communication among the system 102, the user device 104, and the first optimization solver machine 108 may be performed via the communication network 110. The communication network 110 may include a communication medium through which the system 102 may communicate with the first optimization solver machine 108, and different servers (not shown). Examples of the communication network 110 may include, but are not limited to, the Internet, a cloud network, a Wireless Fidelity (Wi-Fi) network, a Personal Area Network (PAN), a Local Area Network (LAN), and/or a Metropolitan Area Network (MAN). Various devices in the network environment 100 may be configured to connect to the communication network 110, in accordance with various wired and wireless communication protocols. Examples of such wired and wireless communication protocols may include, but are not limited to, at least one of a Transmission Control Protocol and Internet Protocol (TCP/IP), User Datagram Protocol (UDP), Hypertext Transfer Protocol (HTTP), File Transfer Protocol (FTP), ZigBee, EDGE, IEEE 802.11, light fidelity(Li-Fi), 802.16, IEEE 802.11s, IEEE 802.11g, multi-hop communication, wireless access point (AP), device to device communication, cellular communication protocols, and/or Bluetooth (BT) communication protocols, or a combination thereof.

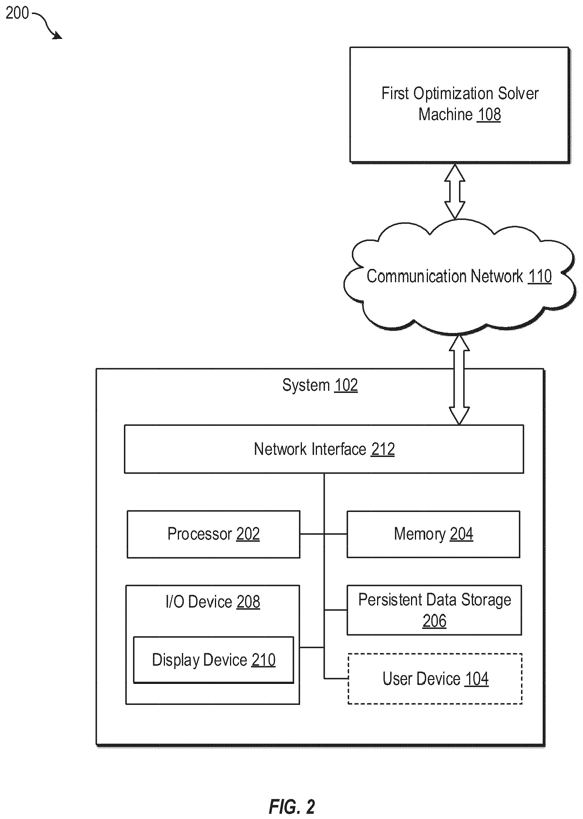

FIG. 2 is a block diagram of a system for solving optimization problems associated with a maritime facility, according to at least one embodiment of the disclosure. FIG. 2 is explained in conjunction with elements from FIG. 1. With reference to FIG. 2, there is shown a block diagram 200 of the system 102. The system 102 may include a processor 202, a memory 204, and a persistent data storage 206. The system 102 may further include an input/output (I/O) device 208 (which may include a display device 210), and a network interface 212. In one or more embodiments, the user device 104 may be included in the system 102.

The processor 202 may include suitable logic, circuitry, and/or interfaces that may be configured to execute program instructions associated with different operations to be executed by the system 102. The processor 202 may include any suitable special-purpose or general-purpose computer, computing entity, or processing device including various computer hardware or software modules and may be configured to execute instructions stored on any applicable computer-readable storage media. For example, the processor 202 may include a microprocessor, a microcontroller, a digital signal processor (DSP), an application-specific integrated circuit (ASIC), a Field-Programmable Gate Array (FPGA), or any other digital or analog circuitry configured to interpret and/or to execute program instructions and/or to process data. Although illustrated as a single processor in FIG. 2, the processor 202 may include any number of processors configured to, individually or collectively, perform or direct performance of any number of operations of the system 102, as described in the present disclosure.

In some embodiments, the processor 202 may be configured to interpret and/or execute program instructions and/or process data stored in the memory 204 and/or the persistent data storage 206. In some embodiments, the processor 202 may fetch program instructions from the persistent data storage 206 and load the program instructions in the memory 204. After the program instructions are loaded into memory 204, the processor 202 may execute the program instructions. Some of the examples of the processor 202 may be a GPU, a CPU, a RISC processor, an ASIC processor, a CISC processor, a co-processor, and/or a combination thereof.

The memory 204 may include suitable logic, circuitry, and/or interfaces that may be configured to store program instructions executable by the processor 202. In certain embodiments, the memory 204 may be configured to store the layout 114, the current location information, and the destination location information associated with the plurality of shipping containers. The memory 204 may include computer-readable storage media for carrying or having computer-executable instructions or data structures stored thereon. Such computer-readable storage media may include any available media that may be accessed by a general-purpose or special-purpose computer, such as the processor 202.

By way of example, and not limitation, such computer-readable storage media may include tangible or non-transitory computer-readable storage media including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices), or any other storage medium which may be used to carry or store particular program code in the form of computer-executable instructions or data structures and which may be accessed by a general-purpose or special-purpose computer. Combinations of the above may also be included within the scope of computer-readable storage media. Computer-executable instructions may include, for example, instructions and data configured to cause the processor 202 to perform a certain operation or group of operations associated with the system 102.

The persistent data storage 206 may include suitable logic, circuitry, and/or interfaces that may be configured to store program instructions executable by the processor 202, operating systems, and/or application-specific information, such as logs and application-specific databases. The persistent data storage may be configured to store information, such as the set of mathematical formulations associated with the seaport optimization problem. The persistent data storage 206 may include computer-readable storage media for carrying or having computer-executable instructions or data structures stored thereon. Such computer-readable storage media may include any available media that may be accessed by a general-purpose or special-purpose computer, such as the processor 202.

By way of example, and not limitation, such computer-readable storage media may include tangible or non-transitory computer-readable storage media including Compact Disc Read-Only Memory (CD-ROM) or other optical disk storage, magnetic disk storage or other magnetic storage devices (e.g., Hard-Disk Drive (HDD)), flash memory devices (e.g., Solid State Drive (SSD), Secure Digital (SD) card, other solid state memory devices), or any other storage medium which may be used to carry or store particular program code in the form of computer-executable instructions or data structures and which may be accessed by a general-purpose or special-purpose computer. Combinations of the above may also be included within the scope of computer-readable storage media. Computer-executable instructions may include, for example, instructions and data configured to cause the processor 202 to perform a certain operation or group of operations associated with the system 102.

The I/O device 208 may include suitable logic, circuitry, interfaces, and/or code that may be configured to receive the layout 114 of a maritime facility and/or inputs, such as via the user device 104. The I/O device 208 may be configured to publish, on the display device 210, a set of paths to be traversed by the fleet of transport vehicles on the maritime facility. The I/O device 208 may include various input and output devices, which may be configured to communicate with the processor 202 and other components, such as the network interface 212. Examples of the input devices may include, but are not limited to, a touch screen, a keyboard, a mouse, a joystick, and/or a microphone. Examples of the output devices may include, but are not limited to, a display (such as the display device 210) and a speaker.

In an embodiment, the display device 210 may include suitable logic, circuitry, interfaces, and/or code that may be configured to display the electronic user interface (UI) 106 onto a display screen of the display device 210. The display device 210 may be realized through several known technologies such as, but not limited to, a Liquid Crystal Display (LCD) display, a Light Emitting Diode (LED) display, a plasma display, and/or an Organic LED (OLED) display technology, and/or other display technologies. Additionally, in some embodiments, the display device 210 may refer to a display screen of smart-glass device, a 3D display, a see-through display, a projection-based display, an electro-chromic display, and/or a transparent display. In an embodiment, the user device 104 may be implemented as a server which may control the display device 210 to display the electronic UI 106.

The network interface 212 may include suitable logic, circuitry, interfaces, and/or code that may be configured to establish a communication between the system 102, the user device104, and the first optimization solver machine 108, via the communication network 110. The network interface 212 may be implemented by use of various known technologies to support wired or wireless communication of the system 102 via the communication network 110. The network interface 212 may include, but is not limited to, an antenna, a radio frequency (RF) transceiver, one or more amplifiers, a tuner, one or more oscillators, a digital signal processor, a coder-decoder (CODEC) chipset, a subscriber identity module (SIM) card, and/or a local buffer.

The network interface 212 may communicate via wireless communication with networks, such as the Internet, an Intranet, and/or a wireless network, such as a cellular telephone network, a wireless local area network (LAN) and/or a metropolitan area network (MAN). The wireless communication may use any of a plurality of communication standards, protocols and technologies, such as Global System for Mobile Communications (GSM), Enhanced Data GSM Environment (EDGE), wideband code division multiple access (W-CDMA), Long Term Evolution (LTE), code division multiple access (CDMA), time division multiple access (TDMA), Bluetooth, Wireless Fidelity (Wi-Fi) (such as IEEE 802.11a, IEEE 802.11b, IEEE 802.11g and/or IEEE 802.11n), voice over Internet Protocol (VoIP), light fidelity (Li-Fi), or Wi-MAX.

Modifications, additions, or omissions may be made to the system 102 without departing from the scope of the present disclosure. For example, in some embodiments, the system 102 may include any number of other components that may not be explicitly illustrated or described.

FIG. 3 is a diagram that illustrates exemplary operations for solving optimization problems associated with a maritime facility, in accordance with an embodiment of the disclosure. FIG. 3 is explained in conjunction with elements from FIG. 1 and FIG. 2. With reference to FIG. 3, there is shown a block diagram 300 that illustrates exemplary operations from 302A to 302H, as described herein. The exemplary operations illustrated in the block diagram 300 may start at 302A and may be performed by any device, apparatus, or computing system, such as by the system 102 of FIG. 1 or FIG. 2. Although illustrated with discrete blocks, the exemplary operations associated with one or more blocks of the block diagram 300 may be divided into additional blocks, combined into fewer blocks, or eliminated, depending on the particular implementation.

At 302A, data acquisition may be performed. For data acquisition, the system 102 may receive a layout 304 of a maritime facility. Examples of the maritime facility may include, but are not limited to, a seaport, a container terminal, an inland (such as a river or canal) port, a dry port, or a cargo port.

The layout 304 of the maritime facility may include current location information associated with a plurality of shipping containers 306 and destination location information associated with the plurality of shipping containers 306. For example, the plurality of shipping containers 306 include a first shipping container 306A, a second shipping container 306B, a third shipping container 306C, a fourth shipping container 306D, a fifth shipping container 306E, a sixth shipping container 306F, and an Nth shipping container 306N. The current location information associated with the plurality of shipping containers 306 may include current geo-coordinates of each of the plurality of shipping containers 306. Similarly, the destination location information may include geo-coordinates of a destination location for each of the plurality of shipping containers 306.

In an embodiment, an image of the maritime facility may be received as the layout 304. The current location information associated with the plurality of shipping containers 306 may be extracted from the received image based on identification of an in-image position of each shipping container in the image. In another embodiment, the current location information and the destination location information associated with the plurality of shipping containers 306 may be received in a tabular format via the electronic UI 106. An example of the current location information and the destination location information associated with a number of shipping containers is provided in Table 1, as follows:

Table 1: Current location information and destination location information associated with a number of shipping containers

| Shipping Container ID | Current location | Destination location |
|---|---|---|
| C1 | (10.125, 23.312) | (10.213, 23.407) |
| C2 | (10.718, 23.877) | (10.901, 23.981) |
| C3 | (11.140, 24.011) | (11.284, 24.244) |
| C4 | (11.570, 25.011) | (11.910, 25.411) |
| C5 | (12.212, 25.251) | (12.510, 26.100) |
| C6 | (13.452, 26.481) | (14.064, 28.152) |
| CN | (15.110, 27.452) | (16.870, 29.087) |

The system 102 may further receive a first input 308. The first input 308 may include a vehicle count associated with a fleet of transport vehicles on the maritime facility. The fleet of transport vehicles may be deployed on the maritime facility for transporting each of the plurality of shipping containers 306 from their current location to a respective destination location. In some embodiments, the received first input 308 may also include a capacity of each transport vehicle of the fleet of transport vehicles. The capacity of a transport vehicle may be associated with a number of shipping containers that can be safely carried by the transport vehicle at a point of time.

In one or more embodiments, the system 102 may receive a second input 310 which may include a condition on a vehicle routing problem. Herein, the vehicle routing problem may be an optimization problem of finding a set of paths (optimal) that the fleet of vehicles may traverse to transport the plurality of shipping containers to respective destination locations on the maritime facility in a shortest amount of time (or in a shortest travel distance or path length). The condition may set a capacity constraint on a number of shipping containers that each transport vehicle in the fleet of transport vehicles may be allowed to carry at once. For example, the condition may require that each transport vehicle transports an equal or a variable number of shipping containers. The second input 310 may be received in case the vehicle count (as specified in the first input 308) is more than 1.

At 302B, a weighted graph representation 312 of the maritime facility may be determined. Such representation may be be determined based on the received layout 304 of the maritime facility. By way of example, and not limitation, from the received layout 304, the system 102 may extract information associated with a number of shipping containers, the current location information associated with the plurality of shipping containers 306 and the destination location information associated with the plurality of shipping containers 306. Thereafter, the system 102 may determine the weighted graph representation 312 based on the extracted information.

The weighted graph representation 312 may include a plurality of nodes 314 and a plurality of edges that may connect each pair of the plurality of nodes 314. For example, the plurality of nodes 314 may include a first node 314A, a second node 314B, a third node 314C, a fourth node 314D, a fifth node 314E, a sixth node 314F, and a Nth node 314N. Each of the plurality of nodes 314 may represent a shipping container of the plurality of shipping containers 306. For example, the first node 314A may represent the first shipping container 306A, the second node 314B may represent the second shipping container 306B, the third node 314C may represent the third shipping container 306C, the fourth node 314D may represent the fourth shipping container 306D, the fifth node 314E may represent the fifth shipping container 306E, the sixth node 314F may represent the sixth shipping container 306F, and Nth node 314N may represent the Nth shipping container 306N.

The position of each node of the weighted graph representation 312 may be set based on a current location of a respective shipping container. The current location may be a datapoint included in the current location information. An edge of the weighted graph representation 312 may include the first node 314A that may be representative of the first shipping container 306A and the second node 314B that may be representative of the second shipping container 306B. The edge in the weighted graph representation 312 may correspond to a route or a path on which a transport vehicle may traverse to transport, for example, the first shipping container 306A at the first node 314A (i.e. the current location) to a destination location within the route, and then move from the destination location to pick-up the second shipping container 306B at the second node 314B, or vice versa.

The weighted graph representation 312 may be determined in such a way that the destination location of a shipping container (at one of the pair of nodes of an edge) may lie on the edge, between the pair of nodes. As an example, a first destination location 316A of the first shipping container 306A may lie on an edge between the first node 314A and the second node 314B. A second destination location 316B of the second shipping container 306B may lie on an edge between the second node 314B and the third node 314C.

Each edge of the weighted graph representation 312 may be associated with a weight value. For example, for the edge between the first node 314A and the second node 314B, the weight value may be cumulative of a first distance between a current location of the first shipping container 306A and the destination location 316A of the first shipping container 306A and a second distance between the destination location 316A of the first shipping container 306A and a current location of the second shipping container 306B. In some embodiments, the weight value associated with the edge may correspond to a cost of traversing the corresponding edge. For example, the cost may be represented in terms of a length of a path joining current positions of two adjacent shipping containers on an edge of the weighted graph representation 312.

In some embodiments, the weighted graph representation 312 may correspond to a fully connected weighted graph representation. An example of weight values associated with the edges of the weighted graph representation 312 is presented in Table 2, as follows:

Table 2: Weights associated with a plurality of edges.

| Edge | | Weight value |
|---|---|---|
| Source Node | Destination Node | |
| First node 314A | Second node 314B | 5 |
| Second node 314B | Third node 314C | 3 |
| Third node 314C | Fourth node 314D | 7 |
| Fourth node 314D | Fifth node 314E | 1 |
| Fifth node 314E | Sixth node 314F | 4 |
| Sixth node 314F | Nth node 314N | 4 |
| Nth node 314N | First node 314A | 8 |
| Second node 314B | Nth node 314N | 17 |

In Table 2, the number of nodes, associated edges between different pairs of nodes, and weight values for the associated edges are merely provided as an example and should not be construed as limiting for the disclosure. The present disclosure may be applicable to a larger or a smaller number of nodes, a larger or a smaller number of edges between different pairs of nodes, and/or different weight values for the associated edges, without a deviation from the scope of the disclosure.

At 302C, it may be determined whether the vehicle count associated with the fleet of transport vehicles on the maritime facility is equal to one. Such a determination may be based on the received first input 308. In one or more embodiments, the system 102 may determine whether the vehicle count associated with the fleet of transport vehicles on the maritime facility is equal to one. In case the vehicle count is greater than one, the control may pass to 402A of FIG. 4. In case the vehicle count is equal to one, the control may pass to 302D.

At 302D, a first mathematical formulation may be selected. The system 102 may select the first mathematical formulation from a set of mathematical formulations based on a determination that the vehicle count associated with the fleet of transport vehicles is equal to one. The first mathematical formulation may model the vehicle routing problem (i.e. an optimization problem) as a Hamiltonian path problem. The Hamiltonian path problem may be a problem for determining a Hamiltonian path in the weighted graph representation 312. The Hamiltonian Path may be a path in the weighted graph representation 312 that may visit each node exactly once and the cost for traversing the Hamiltonian path is a minimum.

The selected first mathematical formulation may include a first objective function and a first set of constrains associated with the first objective function. The first objective function may be optimized to determine a path to be traversed by one transport vehicle in the fleet of transport vehicles for transporting the plurality of shipping containers 306 to respective destination locations (included in the destination location information). The determined path may be referred to as a minimum weighted Hamiltonian path. By way of example, and not limitation, the first objective function of the Hamiltonian path problem for a weighted graph G = (V, E) is provided by equation (1), as follows:

$$\min_{x} \sum_{(u,v) \in E} w_{u,v} \sum_{j=1}^{n} x_{u,j} x_{v,j+1} \qquad (1)$$

Where,

$x_{v,j} = 1$, if a node v is in $j^{th}$ position
$x_{v,j} = 0$, Otherwise
V may correspond to a set that represents the plurality of nodes 314 of the weighted graph representation 312,
E may correspond to a set that represents the plurality of edges of the weighted graph representation 312, and
$w_{u,v}$ may represent a weight value associated with edge u, v.

The first set of constraints/constraint functions associated with the first objective function is provided by equation (2), as follows:

$$\sum_{j=1}^{n} x_{v,j} = 1 \text{ for each } v \qquad (2)$$

$$\sum_{v \in V} x_{v,j} = 1 \text{ for each } j$$

$$\sum_{j=1}^{n-1} x_{u,j} x_{v,j+1} = 0 \text{ if } (u,v) \notin E$$

In the first set of constraints of equation (2), the first constraint ($\sum_{j=1}^{n} x_{v,j} = 1$ for each v) may require that each node of the plurality of nodes 314 be assigned exactly one position in the path. The second constraint of equation (2) may require that each position has exactly one node and the third constraint of equation (2) may require that there must be a path between two nodes that are connected by an edge.

At 302E, a Quadratic Unconstrained Binary Optimization (QUBO) formulation may be generated. The QUBO formulation may be generated by converting the selected first mathematical formulation into a QUBO form. In one or more embodiments, the system 102 may be configured to generate the QUBO formulation by converting the selected first mathematical formulation into the QUBO form.

The QUBO form may be a compatible input format for the first optimization solver machine 108 and may include a cost matrix of constants associated with a vector of binary decision values corresponding to the vector of Binary decision variables. Each variable in the vector of binary decision variables may encode a position of a shipping container of the plurality of shipping containers 306 in the path (to be determined). A generalized QUBO form for any problem is given by equation (3), as follows:

$$\min (y = x^{T} \cdot Q \cdot x) \qquad (3)$$

where,

x may represent the vector of binary decision variables,
and Q may be the cost matrix of constants.

To generate the QUBO formulation, the selected first mathematical formulation may be converted into the QUBO form of equation (3). The generated QUBO formulation may also consider the first set of constraints associated with the first objective function of the selected first mathematical formulation. The QUBO formulation may model the vehicle routing problem associated with the fleet of transport vehicles.

At 302F, the generated QUBO formulation may be submitted to the first optimization solver machine 108 via an application programming interface (API) call. In one or more embodiments, the system 102 may submit the generated QUBO formulation to the first optimization solver machine 108.

The first optimization solver machine 108 may solve the QUBO formulation by application of searching methods and/or meta-heuristic methods, such as quantum annealing, to obtain a first solution of the submitted QUBO formulation. Specifically, to search for the solution (i.e. values of the vector of binary decision variables (x)), the energy of the QUBO formulation may be minimized. The solution may be optimal (or near optimal) and may be searched from a discrete solution space.

For example, a solution of the QUBO formulation from equation (1) may be given by (1), as follows:

| $x_{v,j}$ | j=1 | j=2 | j=3 | j=4 | j=5 | j=6 | j=N |
|---|---|---|---|---|---|---|---|
| v=1 | 1 | 0 | 0 | 0 | 0 | 0 | 0 |
| v=2 | 0 | 1 | 0 | 0 | 0 | 0 | 0 |
| v=3 | 0 | 0 | 1 | 0 | 0 | 0 | 0 |
| v=4 | 0 | 0 | 0 | 1 | 0 | 0 | 0 |
| v=5 | 0 | 0 | 0 | 0 | 1 | 0 | 0 |
| v=6 | 0 | 0 | 0 | 0 | 0 | 1 | 0 |
| v=N | 0 | 0 | 0 | 0 | 0 | 0 | 1 |

(1)

In the solution (1), the positions ($j \in \{1, N\}$) of nodes ($v \in \{1, N\}$) in a path are provided. to obtain a path, the nodes ($v \in \{1, N\}$) may be arranged according to values of x for an increasing order of positions (j). For example, for j = 1, the value of x for the node (v = 1) is 1. Similarly, for j = 2, the value of x for the node (v = 2) is 1.

At 302G, a first solution of the submitted QUBO formulation may be received from the first optimization solver machine 108. In one or more embodiments, the system 102 may receive the first solution of the QUBO formulation. The received first solution may include binary values for the vector of binary decision variables (x).

At 302H, a set of paths may be determined based on the received first solution. In one or more embodiments, the system 102 may determine the set of paths to be traversed by the fleet of transport vehicles on the maritime facility for transporting the plurality of shipping containers 306 to respective destination locations (included in the destination location information).

The determined set of paths may include a single Hamiltonian path 318 that may be traversed by a transport vehicle in the fleet of transport vehicles for transporting the plurality of shipping containers 306 to the respective destination locations (included in the destination location information of the received layout 304). By way of example, and not limitation, the single Hamiltonian path 318 may define an order in which the transport vehicle may pick up shipping containers while traversing on the single Hamiltonian path 318. For example, from the solution (1) at 302F, the single Hamiltonian path 318 may start from the first node 314A to the second node 314B, then continuing from the second node 314B to the third node 314C, from the third node 314C to the fourth node 314D, from the fourth node 314D to the fifth node, 306E, from the fifth node 314E to the sixth node 314F, and from the sixth node 314F at the Nth node 314N.

In some embodiments, the single Hamiltonian path 318 may be overlaid on the layout 304 of the maritime facility. In some other embodiments, the determined single Hamiltonian path 318 may be displayed in a tabular format on the electronic UI 106 of the user device 104. The tabular format may specify an order in which the transport vehicle may be required to pick up and drop the plurality of shipping containers 306.

FIG. 4 is a diagram that illustrates exemplary operations for solving optimization problems when a vehicle count on a maritime facility is greater than one, in accordance with an embodiment of the disclosure. FIG. 3 is explained in conjunction with elements from FIG. 1 FIG.2, and FIG. 3. With reference to FIG. 4, there is shown a block diagram 400 that illustrates exemplary operations from 402A to 402H, as described herein. The exemplary operations illustrated in the block diagram 400 may start at 402A and may be performed by any device, apparatus, or computing system, such as by the system 102 of FIG. 1 or FIG. 2. Although illustrated with discrete blocks, the exemplary operations associated with one or more blocks of the block diagram 400 may be divided into additional blocks, combined into fewer blocks, or eliminated, depending on the particular implementation.

At 402A, it may be determined whether each transport vehicle of the fleet of transport vehicles is allowed to carry equal number of shipping containers. In one or more embodiments, the system 102 may determine whether each transport vehicle of the fleet of transport vehicles is allowed to carry equal number of containers. Such determination may be based on a condition that may be received in the second input 310. The second input 310 may be received in case the vehicle count (as specified in the first input 308) is more than 1. The condition may set a capacity constraint on a number of shipping containers that each transport vehicle in the fleet of transport vehicles may be allowed to carry at once.

In case the condition requires that each transport vehicle transports an equal number of shipping containers, the control may pass to 402B. Otherwise, if the condition requires that each transport vehicle transports a variable number of shipping containers, then the control may pass to 402C. Depending on the requirements of the condition, the vehicle routing problem may be classified under different problem types. The mathematical formulations (such as objective functions and constraints) may vary according to each problem type, as described herein.

At 402B, a second mathematical formulation may be selected from the set of mathematical formulations. Such a selection may be based on the received second input and a determination that the vehicle count is greater than one. The received second input may include the condition requiring each transport vehicle to transport an equal number of shipping containers.

The selected second mathematical formulation may include a second objective function and a second set of constrains associated with the second objective function. The second objective function may be optimized to determine a set of paths to be traversed by the fleet of transport vehicles on the maritime facility for transporting the plurality of shipping containers 306 to respective destination locations (included in the destination location information).

By way of example and not limitation, the second objective function for the weighted graph $G = (V, E)$ is provided by equation (4), as follows:

$$\sum_{(u,v)\in E} w_{uv} \sum_{c=1}^{|C|} \sum_{p=1}^{\frac{n}{m}} x_{u,c,p}x_{v,c,p+1} + x_{v,c,p}x_{u,c,p+1} \tag{4}$$

Where,

$x_{i,j,k} = 1$, if shipping container i is assigned to a vehicle j at position k
$x_{i,j,k} = 0$, Otherwise
V may correspond to a set that represent the plurality of nodes,
E may correspond to a set that represent the plurality of edges,
|C| may represent the vehicle count,
c may represent a transport vehicle,
$w_{u,v}$ may represent the weight associated with edge u, v,
n may represent a number of shipping containers, and
m may represent the vehicle count

The second objective function may be formulated to balancing the number of container loads for each vehicle of the fleet. The second set of constraints/constraint functions associated with the second objective function is provided by equation (5), as follows:

$$\sum_{c=1}^{|C|} \sum_{p=1}^{\frac{n}{m}} x_{v,c,p} = 1 \tag{5}$$

$$\sum_{v\in V} \sum_{p=1}^{\frac{n}{m}} x_{v,c,p} = \frac{n}{m}$$

$$\sum_{c\in C} \sum_{p=1}^{\frac{n}{m}} x_{v,c,p} = 1$$

In the second set of constraints of equation (5), the first constraint $\left(\sum_{c=1}^{|C|} \sum_{p=1}^{\frac{n}{m}} x_{v,c,p} =1\right)$ may require that each node of the plurality of nodes 314 must be traversed by exactly one vehicle. From equation (5), the second constraint

$$\sum_{v \epsilon V} \sum_{p=1}^{\frac{n}{m}} x_{v,c,p} = \frac{n}{m})$$

may require that each vehicle carries n/m shipping containers. From equation (5), the third constraint may require that each tuple $(x_{v,c,p})$ consisting of an identifier $(c \in C)$ of a transport vehicle and its position

$\left(p \in \{1, \frac{n}{m}\}\right)$ includes exactly one node of the plurality of nodes 314.

At 402C, a third mathematical formulation may be selected from the set of mathematical formulations. Such a selection may be based on the received second input and a determination that the vehicle count is greater than one. The condition may require that each transport vehicle in the fleet of transport vehicles transports a variable number of shipping containers from the plurality of shipping containers 306. The selected third mathematical formulation may include a third objective function and a third set of constraints associated with the third objective function. The third objective function may be optimized to determine a set of paths to be traversed by the fleet of transport vehicles on the maritime facility for transporting the plurality of shipping containers 306 to respective destination locations (included in the destination location information).

By way of example, and not limitation, the third objective function for the weighted graph G = (V, E) may target is provided by equation (6), as follows:

$$\sum_{i,j,k} w_{i,j} x_{i,j,k} \tag{6}$$

Where,

$x_{i,j,k}$ = 1, if edge (i, j) is used by vehicle k
$x_{i,j,k}$ = 0, Otherwise
V may correspond to a set that represent the plurality of nodes,
and
E may correspond to a set that represent the plurality of edges,

The third objective function may be formulated to minimize a difference between the length of a path taken by each transport vehicle of the fleet. The third set of constraints/constraint functions associated with the third objective function is provided by equation (7), as follows:

Flow Conservation (Flow in = Flow out for a transport vehicle):

$$\sum_{j} x_{v,j,k} - \sum_{j} x_{j,v,k} = \begin{cases} k, v=s \\ 0, v \neq s, j \neq t, \forall v \\ -k, v=t \end{cases}$$

Each node must be in a path (Flow out =1, for each node):

$$\sum_{c \in C} x_{v,j,k} = \begin{cases} k, v=s \\ 1, v, \forall v \in V \backslash \{t\},k \\ 0, v=t \text{ (trivally holds)} \end{cases} \tag{7}$$

Balance length of paths for each transport vehicle:

$$|P_i| = |P_j|$$

where

$$|P_k| = \sum_{i,j} w_{i,j}\, x_{i,j,k}$$

In equation (7), the first constraint of the third set of constraints may require that the flow of each transport vehicle should be conserved. The conservation of the flow of a transport vehicle may correspond that the flow-in of a corresponding transport vehicle may be equal to or approximately equal to a flow-out of the corresponding transport vehicle.

The second constraint of the third set of constraints may require that each node of the plurality of nodes should be on at least one path. For each node of the plurality of nodes to be on at least one path, the flow-out may be equal to 1 for each node.

The third constraint of the third set of constraints may require that a length of each path of the determined set of paths should be equal. Therefore, the difference between length of each path may be equal to zero or approximately equal to zero and is provided by equation (8), as follows:

$$\sum_{i,j} w_{i,j}x_{i,j,1} \;-\; \sum_{i,j} w_{i,j}x_{i,j,2} \;=\; 0$$

$$\sum_{i,j} w_{i,j}x_{i,j,2} \;-\; \sum_{i,j} w_{i,j}x_{i,j,3} \;=\; 0$$

$$\vdots \qquad\qquad\qquad\qquad\qquad\qquad\qquad (8)$$

$$\sum_{i,j} w_{i,j}x_{i,j,k\text{-}1} \;-\; \sum_{i,j} w_{i,j}x_{i,j,k} \;=\; 0$$

$$\sum_{i,j} w_{i,j}x_{i,j,k} \;-\; \sum_{i,j} w_{i,j}x_{i,j,1} \;=\; 0$$

At 402D, a first QUBO formulation may be generated based on the selected second mathematical formulation. The selected second mathematical formulation may be converted into a QUBO form. The QUBO form may be a compatible input format for the first optimization solver machine 108 and may include a cost matrix of constants associated with a vector of binary decision variables (x). Details about the generation of a QUBO formulation are provided, for example, in FIG. 3.

At 402E, a second QUBO formulation may be generated based on the selected third mathematical formulation. The selected third mathematical formulation may be converted into a QUBO form. The QUBO form may be a compatible input format for the first optimization solver machine 108 and may include a cost matrix of constants associated with a vector of Boolean variables. Details about the generation of a QUBO formulation are provided, for example, in FIG. 3.

At 402F, the generated QUBO formulation may be submitted to the first optimization solver machine 108 via an application programming interface (API) call. The first optimization solver machine 108 may solve the QUBO formulation by application of searching methods and/or meta-heuristic methods, such as quantum annealing, to obtain a solution of the submitted QUBO formulation. Details about the submission of the generated QUBO formulation is described, for example, in FIG. 3.

At 402G, a first solution of the submitted QUBO formulation may be received from the first optimization solver machine 108. The received solution may include binary values for the vector of binary decision variables (x) of the QUBO formulation. In one or more embodiments, the system 102 may be configured to receive the solution of the QUBO formulation. Details about the submission of the generated QUBO formulation are described, for example, in FIG. 3.

At 402H, a set of paths 404 may be determined. The set of paths 404 may be determined based on the received first solution. The determined set of paths 404 may include a first path which may determine an order in which a first transport vehicle of the fleet of transport vehicles may be required to transport at least one shipping container of the plurality of shipping containers 306 to at least one destination location such that a length of the first path is shortest.

In some embodiments, the set of paths 404 may be determined based on a starting position of each transport vehicle of the fleet of transport vehicles. For example, the first container to be picked up by the first transport vehicle may be closest to the first transport vehicle.

In case the QUBO formulation is generated based on the second mathematical formulation, the determined set of paths 404 may include a unique path to be traversed by each transport vehicle in the fleet of transport vehicles for transporting an equal number of shipping containers to at least one destination location (included in the destination location information). For example, the determined set of paths 404 may include 3 paths for 3 vehicles. The path for a 'Vehicle 1' may start from the first node 314A to the second node 314B, and then from the second node 314B to the third node 314C. Similarly, the path for a 'Vehicle 2' may start from the third node 314C to the fourth node 314D, and then from the fourth node 314D to the fifth node 314E. Similarly, the path for a 'Vehicle 3' may start from the fifth node 314E to the sixth node 314F, and from the sixth node 314F to the Nth node 314N. As shown, in the determined set of paths 404, each vehicle carries 3 shipping containers (i.e. an equal number of shipping containers) to their respective destination locations while traversing a different path on the maritime facility.

In case the QUBO formulation is generated based on the third mathematical formulation, the set of paths may include a unique path to be traversed by each transport vehicle in the fleet of transport vehicles for transporting a variable number of shipping container to at least one destination location (included in the destination location information).

For example, the set of paths may include 3 paths for 3 vehicles. The path for a 'Vehicle 1' may start from the first node 314A to the second node 314B, and then from the second node 314B to the third node 314C, and then from the third node 314C to the fourth node 314D. Similarly, the path for a 'Vehicle 2' may extend from the fourth node 314D to the fifth node 314E. Similarly, the path for a 'Vehicle 3' may start from the fifth node 314E to the sixth node 314F, and from the sixth node 314F to the Nth node 314N. In the foregoing example, vehicles carry a variable number of shipping containers to their respective destination locations while traversing different paths on the maritime facility.

In an exemplary scenario, before determining the set of paths, a constraint on balancing a path length (i.e. length of a path) for each transport vehicle of the fleet may be considered. In such a case, the length of a first path in the determined set of paths and the length of a second path in the determined set of paths may be equal or approximately equal. For example, the length of the path for the 'Vehicle 1' may be equal or approximately equal to the length of the path for the 'Vehicle 2'.

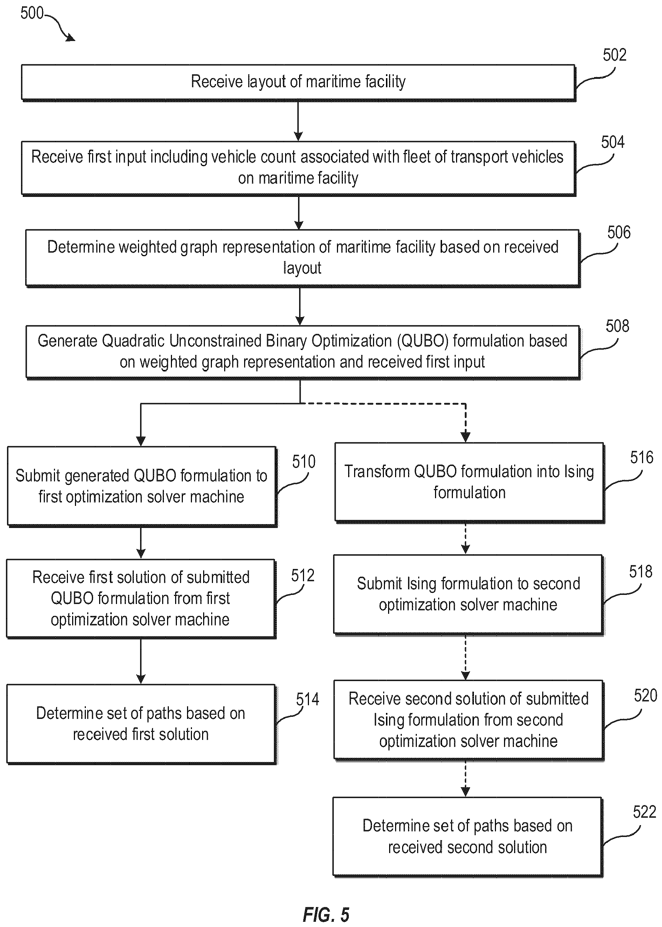

FIG. 5 is a flowchart of an example method for solving optimization problems on different optimization solver machines, arranged in accordance with at least one embodiment described in the present disclosure. FIG. 5 is explained in conjunction with elements from FIG. 1, FIG. 2, FIG. 3, and FIG. 4. With reference to FIG. 5, there is shown a flowchart 500. The example method illustrated in the flowchart 500 may start at 502 and may be performed by any suitable system, apparatus, or device, such as by the system 102 of FIG. 2.

At 502, the layout 304 of a maritime facility (such as a seaport or an inland port) may be received. In one or more embodiments, the processor 202 may be configured to receive the layout 304 of the maritime facility. The layout 304 may include current location information associated with the plurality of shipping containers 306 and destination location information associated with the plurality of shipping containers 306. In some embodiments, an image may be received as the layout 304 of the maritime facility. In some other embodiments, the current location information associated with the plurality of shipping containers 306 and the destination location information associated with the plurality of shipping containers 306 may be received in a tabular format

At 504, the first input 308 may be received. The first input 308 may include a vehicle count associated with a fleet of transport vehicles on the maritime facility. In one or more embodiments, the processor 202 may be configured to receive the first input 308 that includes the vehicle count associated with the fleet of transport vehicles on the maritime facility. The fleet of transport vehicles may transport each of the plurality of shipping containers 306 from a current location (included in the current location information) to a respective destination location (included in the destination location information).

At 506, a weighted graph representation 312 of the maritime facility may be determined based on the received layout 304. In one or more embodiments, the processor 202 may be configured to determine the weighted graph representation 312 of the maritime facility. The weighted graph representation 312 may include the plurality of nodes 314 and a plurality of edges. Each of the plurality of nodes 314 may represent a shipping container of the plurality of shipping containers 306. Each edge of the weighted graph representation 312 may include the first node 314A that may be representative of the first shipping container 306A and the second node 314B that may be representative of the second shipping container 306B. An edge of the weighted graph representation 312 may be associated with a weight value which may be cumulative of a first distance between a current location of the first shipping container 306A and a destination location of the first shipping container 306A and a second distance between the destination location of the first shipping container 306A and a current location of the second shipping container 306B.

At 508, a Quadratic Unconstrained Binary Optimization (QUBO) formulation may be generated. The QUBO formulation may be generated based on the determined weighted graph representation 312 and the received first input 308 308. The QUBO formulation may model a vehicle routing problem associated with the fleet of transport vehicles. Herein, the vehicle routing problem may be an optimization problem of finding a set of paths (optimal) that the fleet of vehicles may traverse, to transport the plurality of shipping containers 306 to respective destination locations on the maritime facility in a shortest amount of time (or a shortest travel distance or path length).

The generated QUBO formulation may include a cost matrix of constants associated with a vector of binary decision variables. Each variable in the vector of binary decision variables may encode a position of a shipping container of the plurality of shipping containers 306 in a first path of the determined set of paths. In one or more embodiments, the processor 202 may be configured to generate the QUBO formulation based on the determined weighted graph representation 312 and the received first input 308 308.

At 510, the generated QUBO formulation may be submitted to the first optimization solver machine 108 via an application programming interface (API) call. In one or more embodiments, the processor 202 may be configured to submit the generated QUBO formulation to the first optimization solver machine 108.

At 512, a first solution of the submitted QUBO formulation may be received from the first optimization solver machine 108. The received solution may include binary values for the vector of binary decision variables of the QUBO formulation. In one or more embodiments, the processor 202 may be configured to receive the solution of the QUBO formulation from the first optimization solver machine 108.

At 514, the set of paths may be determined. In one or more embodiments, the processor 202 may be configured to determine the set of paths 404 based on the received first solution. The set of paths may be traversed by the fleet of transport vehicles on the maritime facility for transporting the plurality of shipping containers 306 to destination locations (included in the destination location information). The determined set of paths may include a first path which determines an order in which a first transport vehicle of the fleet of transport vehicles may be required to transport at least one shipping container of the plurality of shipping containers 306 to at least one destination location such that a length of the first path is shortest

At 516, the generated QUBO formulation may be transformed into an ising formulation. The Ising formulation may be a compatible input format for a set of Ising processing units of a second optimization solver machine which may be same as or different from the first optimization solver machine 108. In the Ising formulation, attributes and relationship among the attributes are based on an Ising model. The Ising model is a mathematical model of ferromagnetism in reference to statistical mechanics. The model uses discrete variables which represent the magnetic dipole moments of spin states, (which are either +1 or -1). The datapoints (which are represented as the spin states) may be organized as a lattice so each spin may interact with its neighbors.

The solution of the Ising formulation may be differ from that of the QUBO formulation with respect to selection of values for the vector of binary decision variables. For the QUBO formulation, the binary value for a decision variable may be represented as one of 0 or 1. Whereas, for the Ising formulation, the binary value for a decision variable may be represented as one of -1 or +1 (which may be analogous to two spin states of an Ising system).

At 518, the ising formulation may be submitted to the second optimization solver machine. The second optimization solver machine may include the set of Ising processing units that may be configured to solve the Ising formulation(s). In one or more embodiments, each Ising processing unit may be a software module or hard-based device that may be configured to run on the second optimization solver machine. Each Ising processing unit may correspond to a mathematical abstraction of an Ising model for solving the Ising formulation. The Ising model may be a mathematical model concerned with the physics of phase transitions, which occur when a small change in a parameter causes a large-scale, qualitative change in the state of a system. The properties of a magnetic material may be determined by magnetic spins, which can be oriented up (+1) or down (-1). The Ising model may be expressed in terms of the individual spin states (+1/-1), the interaction coefficients that represent the strength of the intersections between different pairs of spin states, and the external magnetic coefficients that represent the strength of the external magnetic field. Therefore, a solution of the Ising formulation may be analogous to spin states for a minimum energy configuration of the Ising model.

The set of Ising Processing Units may be configured to solve the Ising formulation by searching for values of binary decision variables (+1/-1) of the Ising formulation from a discrete solution space such that the energy (analogous to energy of the Ising Model) of the Ising formulation is a minimum.

The Ising formulation may be provided as an input to the second optimization solver machine to generate a second solution for the optimization problem of vehicle routing by solving the Ising formulation. In one or more embodiments, the processor 202 may submit the Ising formulation to the second optimization solver machine. By way of example and not limitation, the Ising formulation may be submitted to the second optimization solver machine via an API request For example, a call (e.g., API call) may be sent to the second optimization solver machine to generate the second solution to the Ising formulation.

At 520, a second solution of the submitted ising formulation may be received from the second optimization solver machine. The received second solution may include binary values for the vector of binary decision variables of the ising formulation.

The second optimization solver machine may apply searching methods and/or meta-heuristic methods, such as quantum annealing, to search for the second solution to the Ising formulation from a discrete solution space by finding a global minimum (i.e. analogous to a minimum energy state of an Ising system) of the Ising formulation. In one or more embodiments, the processor 202 may be configured to receive the second solution of the ising formulation from the second optimization solver machine.

At 522, the set of paths 404 may be determined. The determined set of paths may be traversed by the fleet of transport vehicles on the maritime facility for transporting the plurality of shipping containers 306 to destination locations included in the destination location information.

Control may pass to end. Although the flowchart 500 is illustrated as discrete operations, such as 502, 504, 506, 508, 510, 512, 514, 516, 518, 520, and 522; however, in certain embodiments, such discrete operations may be further divided into additional operations, combined into fewer operations, or eliminated, depending on the particular implementation.

Various embodiments of the disclosure may provide a non-transitory computer-readable storage medium configured to store instructions that, in response to being executed, causes a system (such as the system 102) to perform operations that include receiving a layout of a maritime facility. The layout may include current location information associated with a plurality of shipping containers and destination location information associated with the plurality of shipping containers. The operations may further include receiving a first input that may include a vehicle count associated with a fleet of transport vehicles on the maritime facility. The operations may further include determining a weighted graph representation of the maritime facility based on the received layout and generating a Quadratic Unconstrained Binary Optimization (QUBO) formulation based on the weighted graph representation and the received first input The QUBO formulation models a vehicle routing problem associated with the fleet of transport vehicles. The operations may further include submitting the generated QUBO formulation to a first optimization solver machine (such as the first optimization solver machine 108) and receiving a first solution of the submitted QUBO formulation from the first optimization solver machine. The operations may further include determining a set of paths to be traversed by the fleet of transport vehicles on the maritime facility for transporting the plurality of shipping containers to destination locations included in the destination location information based on the received first solution.

As used in the present disclosure, the terms "module" or "component" may refer to specific hardware implementations configured to perform the actions of the module or component and/or software objects or software routines that may be stored on and/or executed by general purpose hardware (e.g., computer-readable media, processing devices, etc.) of the computing system. In some embodiments, the different components, modules, engines, and services described in the present disclosure may be implemented as objects or processes that execute on the computing system (e.g., as separate threads). While some of the system and methods described in the present disclosure are generally described as being implemented in software (stored on and/or executed by general purpose hardware), specific hardware implementations or a combination of software and specific hardware implementations are also possible and contemplated. In this description, a "computing entity" may be any computing system as previously defined in the present disclosure, or any module or combination of modulates running on a computing system.

Terms used in the present disclosure and especially in the appended claims (e.g., bodies of the appended claims) are generally intended as "open" terms (e.g., the term "including" should be interpreted as "including, but not limited to," the term "having" should be interpreted as "having at least," the term "includes" should be interpreted as "includes, but is not limited to," etc.).

Additionally, if a specific number of an introduced claim recitation is intended, such an intent will be explicitly recited in the claim, and in the absence of such recitation no such intent is present. For example, as an aid to understanding, the following appended claims may contain usage of the introductory phrases "at least one" and "one or more" to introduce claim recitations. However, the use of such phrases should not be construed to imply that the introduction of a claim recitation by the indefinite articles "a" or "an" limits any particular claim containing such introduced claim recitation to embodiments containing only one such recitation, even when the same claim includes the introductory phrases "one or more" or "at least one" and indefinite articles such as "a" or "an" (e.g., "a" and/or "an" should be interpreted to mean "at least one" or "one or more"); the same holds true for the use of definite articles used to introduce claim recitations.

In addition, even if a specific number of an introduced claim recitation is explicitly recited, those skilled in the art will recognize that such recitation should be interpreted to mean at least the recited number (e.g., the bare recitation of "two recitations," without other modifiers, means at least two recitations, or two or more recitations). Furthermore, in those instances where a convention analogous to "at least one of A, B, and C, etc." or "one or more of A, B, and C, etc." is used, in general such a construction is intended to include A alone, B alone, C alone, A and B together, A and C together, B and C together, or A, B, and C together, etc.

Further, any disjunctive word or phrase presenting two or more alternative terms, whether in the description, claims, or drawings, should be understood to contemplate the possibilities of including one of the terms, either of the terms, or both terms. For example, the phrase "A or B" should be understood to include the possibilities of "A" or "B" or "A and B."

All examples and conditional language recited in the present disclosure are intended for pedagogical objects to aid the reader in understanding the present disclosure and the concepts contributed by the inventor to furthering the art, and are to be construed as being without limitation to such specifically recited examples and conditions. Although embodiments of the present disclosure have been described in detail, various changes, substitutions, and alterations could be made hereto without departing from the spirit and scope of the present disclosure.

**Claims**

1.  A method, comprising:

    receiving a layout of a maritime facility, the layout comprising current location information associated with a plurality of shipping containers and destination location information associated with the plurality of shipping containers;
    receiving a first input comprising a vehicle count associated with a fleet of transport vehicles on the maritime facility;
    determining a weighted graph representation of the maritime facility based on the received layout;
    generating a Quadratic Unconstrained Binary Optimization (QUBO) formulation based on the weighted graph representation and the received first input,
    the QUBO formulation models a vehicle routing problem associated
    with the fleet of transport vehicles;
    submitting the generated QUBO formulation to a first optimization solver machine;
    receiving a first solution of the submitted QUBO formulation from the first optimization solver machine; and
    determining, based on the received first solution, a set of paths to be traversed by the fleet of transport vehicles on the maritime facility for transporting the plurality of shipping containers to destination locations included in the destination location information.

2.  The method according to claim 1, wherein the weighted graph representation comprises a plurality of nodes, each of which represents a shipping container of the plurality of shipping containers.

3.  The method according to claim 1, wherein

    each edge of the weighted graph representation comprises a first node representative of a first shipping container and a second node representative of a second shipping container, and
    each edge of the weighted graph representation is associated with a weight value which is cumulative of:

    a first distance between a current location of the first shipping container and a destination location of the first shipping container, and
    a second distance between the destination location of the first shipping container and a current location of the second shipping container.

4.  The method according to claim 1, further comprising:

    selecting, from a set of mathematical formulations, a first mathematical formulation which models the vehicle routing problem as a Hamiltonian path problem,
    wherein the first mathematical formulation is selected based on a determination that the vehicle count is equal to one; and
    generating the QUBO formulation by converting the selected first mathematical formulation into a QUBO form.

5.  The method according to claim 4, wherein, for the QUBO formulation generated by converting the selected first mathematical formulation, the determined set of paths consists of a single Hamiltonian path to be traversed by a transport vehicle in the fleet of transport vehicles for transporting the plurality of shipping containers to the destination locations included in the destination location information.

6.  The method according to claim 1, further comprising:

    receiving a second input comprising a condition on the vehicle routing problem,
    the condition requiring that each transport vehicle in the fleet of transport vehicles transports an equal number of shipping containers from the plurality of shipping containers;

selecting, from a set of mathematical formulations, a second mathematical formulation to model the vehicle routing problem,

wherein the second mathematical formulation is selected based on the received second input and a determination that the vehicle count is greater than one; and

generating the QUBO formulation by converting the selected second mathematical formulation into a QUBO form.

7. The method according to claim 6, wherein, for the QUBO formulation generated by converting the selected second mathematical formulation, the determined set of paths comprises a unique path to be traversed by each transport vehicle in the fleet of transport vehicles for transporting the equal number of shipping containers to at least one destination location included in the destination location information.

8. The method according to claim 1, further comprising:

receiving a second input comprising a condition on the vehicle routing problem,

the condition requiring that each transport vehicle in the fleet of transport vehicles transports a variable number of shipping containers from the plurality of shipping containers;

selecting, from a set of mathematical formulations, a third mathematical formulation to model the vehicle routing problem,

wherein the third mathematical formulation is selected based on the received second input and a determination that the vehicle count is greater than one; and

generating the QUBO formulation by converting the selected third mathematical formulation into a QUBO form.

9. The method according to claim 8, wherein, for the QUBO formulation generated by converting the selected third mathematical formulation, the determined set of paths comprises a unique path to be traversed by each transport vehicle in the fleet of transport vehicles for transporting the variable number of shipping container to at least one destination location included in the destination location information.

10. The method according to claim 9, wherein a length of a first path in the determined set of paths and a length of a second path in the determined set of paths is equal or approximately equal.

11. The method according to claim 1, wherein

the generated QUBO formulation comprises a cost matrix of constants associated with a vector of binary decision variables, and

each variable in the vector of binary decision variables encodes a position of a shipping container of the plurality of shipping containers in a first path of the determined set of paths.

12. The method according to claim 1, wherein the determined set of paths comprises a first path which determines an order in which a first transport vehicle of the fleet of transport vehicles is required to transport at least one shipping container of the plurality of shipping containers to at least one destination location such that a length of the first path is shortest.

13. The method according to claim 1, further comprising:

transforming the QUBO formulation into an Ising formulation; and

submitting the Ising formulation to a second optimization solver machine.

14. The method according to claim 13, further comprising:

receiving, from the second optimization solver machine, a second solution of the submitted Ising formulation; and

determining the set of paths based on the received second solution.

15. A non-transitory computer-readable storage medium configured to store instructions that, in response to being executed, causes a system to perform operations, the operations comprising:

receiving a layout of a maritime facility, the layout comprising current location information associated with a plurality of shipping containers and destination location information associated with the plurality of shipping containers;

receiving a first input comprising a vehicle count associated with a fleet of transport vehicles on the maritime facility;

determining a weighted graph representation of the maritime facility based on the received layout;

generating a Quadratic Unconstrained Binary Optimization (QUBO) formulation based on the weighted graph representation and the received first input,

the QUBO formulation models a vehicle routing problem associated with the fleet of transport vehicles;

submitting the generated QUBO formulation to a first optimization solver machine;

receiving a first solution of the submitted QUBO formulation from the first optimization solver machine; and

determining, based on the received first solution, a set of paths to be traversed by the fleet of transport vehicles on the maritime facility for transporting the plurality of shipping containers to destination locations included in the destination location information.

16. The non-transitory computer-readable storage medium according to claim 15, wherein the weighted graph representation comprises a plurality of nodes, each of which represents a shipping container of the plurality of shipping containers.

17. The non-transitory computer-readable storage medium according to claim 15, wherein

each edge of the weighted graph representation comprises a first node representative of a first shipping container and a second node representative of a second shipping container, and

each edge of the weighted graph representation is associated with a weight value which is cumulative of:

a first distance between a current location of the first shipping container and a destination location of the first shipping container, and

a second distance between the destination location of the first shipping container and a current location of the second shipping container.

18. The non-transitory computer-readable storage medium according to claim 15, wherein

the generated QUBO formulation comprises a cost matrix of constants associated with a vector of binary decision variables,

each variable in the vector of binary decision variables encodes a position of a shipping container of the plurality of shipping containers in a first path of the determined set of paths.

19. The non-transitory computer-readable storage medium according to claim 15, further comprising:

transforming the QUBO formulation into an Ising formulation;

submitting the Ising formulation to a second optimization solver machine;

receiving, from the second optimization solver machine, a second solution of the submitted Ising formulation; and

determining the set of paths based on the received second solution.

20. A system, comprising:
a processor configured to:

receive a layout of a maritime facility, the layout comprising current location information associated with a plurality of shipping containers and destination location information associated with the plurality of shipping containers;

receive a first input comprising a vehicle count associated with a fleet of transport vehicles on the maritime facility;

determine a weighted graph representation of the maritime facility based on the received layout;

generate a Quadratic Unconstrained Binary Optimization (QUBO) formulation based on the weighted graph representation and the received first input,

the QUBO formulation models a vehicle routing problem associated with the fleet of transport vehicles;

submit the generated QUBO formulation to a first optimization solver machine;

receive a first solution of the submitted QUBO formulation from the first optimization solver machine; and

determine, based on the received first solution, a set of paths to be traversed by the fleet of transport vehicles on the maritime facility for transporting the plurality of shipping containers to destination locations included in the destination location information.

**FIG. 1**

200

First Optimization Solver
Machine 108

Communication Network 110

System 102

Network Interface 212

Processor 202

Memory 204

I/O Device 208

Persistent Data Storage
206

Display Device 210

User Device 104

*FIG. 2*

FIG. 3

400

A

Whether
Transport vehicle can
carry equal number
of containers?
402A

No

Yes

Third
Mathematical
Formulation
Selection 402C

Second QUBO
Formulation
Generation 402E

Second
Mathematical
Formulation
Selection 402B

First QUBO
Formulation
Generation 402D

QUBO
Formulation
Submission
402F

Solution
Reception 402G

Paths
Determination
402H

### Set of Paths 404

| Vehicle No. | Path |
|---|---|
| Vehicle 1 | 314A → 314B → 314C |
| Vehicle 2 | 314C → 314D → 314E |
| Vehicle 3 | 314E → 314F → 314N |

*FIG. 4*

500

502 Receive layout of maritime facility

504 Receive first input including vehicle count associated with fleet of transport vehicles on maritime facility

506 Determine weighted graph representation of maritime facility based on received layout

508 Generate Quadratic Unconstrained Binary Optimization (QUBO) formulation based on weighted graph representation and received first input

510 Submit generated QUBO formulation to first optimization solver machine

512 Receive first solution of submitted QUBO formulation from first optimization solver machine

514 Determine set of paths based on received first solution

516 Transform QUBO formulation into Ising formulation

518 Submit Ising formulation to second optimization solver machine

520 Receive second solution of submitted Ising formulation from second optimization solver machine

522 Determine set of paths based on received second solution

*FIG. 5*

Europäisches
Patentamt

European
Patent Office

Office européen
des brevets

# EUROPEAN SEARCH REPORT

**Application Number**

**EP 21 18 9375**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FRANK PHILLIPSON ET AL: "Multimodal Container Planning: a QUBO Formulation and Implementation on a Quantum Annealer", ARXIV.ORG, CORNELL UNIVERSITY LIBRARY, 201 OLIN LIBRARY CORNELL UNIVERSITY ITHACA, NY 14853, 3 July 2020 (2020-07-03), XP081714324, * abstract * * sections 1-3 * ----- | 1-20 | INV. G06Q10/04 G06Q50/28 |
| X | WO 2018/119522 A1 (1QB INF TECH INC [CA]) 5 July 2018 (2018-07-05) * paragraph [0003]; figure 1 * ----- | 1-20 | |

**TECHNICAL FIELDS SEARCHED (IPC)**

G06Q

The present search report has been drawn up for all claims

| Place of search | Date of completion of the search | Examiner |
|---|---|---|
| Munich | 17 January 2022 | Haitof, Houssam |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 18 9375

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2022

| Patent document cited in search report | Publication date | Patent family member(s) | Publication date |
|---|---|---|---|
| WO 2018119522 A1 | 05-07-2018 | US 2018246851 A1<br>WO 2018119522 A1 | 30-08-2018<br>05-07-2018 |

EPO FORM P0459

For more details about this annex : see Official Journal of the European Patent Office, No. 12/82